# EUROPEAN PATENT APPLICATION

(11) **EP 2 184 850 A1**
(43) Date of publication of application: **12.05.2010**
(21) Application number: 08168769.1
(22) Date of filing: 10.11.2008
(51) Int. Cl.: H03F 1/30

(54) **Biased power amplifier**

(71) Applicant: Nederlandse Organisatie voor toegepast-natuurwetenschappelijk onderzoek TNO, 2628 VK Delft (NL)
(72) Inventor: van Wanum, Maurice, 2274 HW Den Haag (NL); de Hek, Andries Peter, 3371 HX Hardinxveld Giessendam (NL); Busking, Erik Bert, 2564 TK Den Haag (NL)
(74) Representative: Hatzmann, Martin

(57) **Abstract**

A power amplifier with a normally on amplifying transistor (100) is biased from a bias stage (12) and a buffer circuit (14). The bias stage (12) comprises a normally on bias transistor (120) in a reference configuration wherein a current through a main current channel of the bias transistor (120) depends on a threshold voltage value of the bias transistor (120). The combination of the bias stage (12) and the buffer circuit (14) has a voltage gain of two from a control electrode of the bias transistor (120) to the control electrode of the amplifying transistor (100) when the bias stage has one source follower transistor between the bias stage and the control electrode of the amplifying transistor, or more generally a gain of an integer factor equal to one plus a count of buffer transistors (140) coupled between the bias transistor (120) and the amplifying transistor (100) in the buffer circuit (14).

## Description

### Field of the invention

The invention relates to a power amplifier comprising an amplifying transistor and a bias circuit for the amplifying transistor.

### Background

W02007064201 discloses a power amplifier with an amplifying transistor of "normally on" type and a bias circuit that supplies a bias voltage to the gate of the amplifying transistor. The source of the amplifying transistor is coupled to ground and the drain is coupled to a positive power supply via a load impedance. An RF input is coupled to the gate via a capacitor. A "normally on" transistor is a transistor that can be switched to a non-conductive state only by a control electrode voltage outside the range of voltage values between the voltages at the terminals of its main current channel. This type of amplifying circuit suffers from deviations from the nominal threshold voltage of the amplifying transistor, due to manufacturing tolerances and/or temperature fluctuations.

The bias circuit is used to vary the gate voltage of the amplifying transistor in such a way that the threshold voltage deviations are compensated. The bias circuit comprises a bias transistor of the same "normally on" type as the amplifying transistor, with a drain coupled to ground via a drain resistance. To supply the bias voltage the drain is connected to the gate of the amplifying transistor via an RF blocking element such as a choke coil. The source and gate of the bias transistor are coupled to a negative power supply via respective resistors. The drain resistance has a value selected to ensure that the bias transistor circuit provides unity gain of the difference between the bias transistor's gate-source voltage and its own threshold voltage. As a result, the amplifying transistor receives a gate voltage that varies with deviations of the threshold voltage of the bias transistor. Thus the difference between the gate-source voltage of the amplifying transistor and its threshold voltage may be kept independent of the deviations.

This circuit has been found to have the problem a bias shift may occur when a large RF signal swing is applied to the amplifying transistor, which disturbs the compensation.

### Summary

Among others it is an object to counteract the effects of large signal swing at the amplifying transistor without losing compensation for deviations of the threshold voltage.

A power amplifier according to claim 1 is provided, with a bias stage that is coupled to the control electrode of an amplifying transistor via a buffer circuit. The bias stage comprises a bias transistor and at least both at least the amplifying transistor and the bias transistor are of the same "normally on" type. The bias stage controls a bias voltage at the control electrode of the amplifying transistor and the buffer stage prevents that the bias stage is affected by DC current shift in the bias line resulting from the signal swing at the amplifying transistor. The bias stage compensates for deviations of the threshold voltage of both the amplifying transistor and one or more buffer transistors in the buffer stage, by providing voltage gain of substantially an integer factor from the control electrode of the bias transistor to the control electrode of the amplifying transistor.

In an embodiment exactly one buffer transistor is used, in which case said gain is two. When a larger number of buffer transistors is used the integer factor may be correspondingly higher, so that the integer factor equals one plus the number (one or higher) of buffer transistors coupled between the bias stage and the control electrode of the amplifying transistor.

In an embodiment field effect transistors may be used, the buffer transistor or buffer transistors being coupled in source follower configuration between the bias stage and the control electrode of the amplifying transistor. As used herein "source follower configuration" of a buffer transistor means that in the bias signal path from the bias stage to the amplifying transistor the control electrode (gate) of the buffer transistor is coupled towards the bias stage and the source is coupled towards the gate of the amplifying transistor.

In an embodiment the bias transistor is a field effect transistor with a source resistance and a drain resistance coupled to different power supply connections. In this embodiment the required gain may be realized through the selection of the resistance values of these resistances. Preferably, these source and drain resistances determine the entire gain, but if further transistors are used between the bias transistor and the gate of the amplifying transistor, the resistance values may compensate for gain or attenuation factors due to such transistors.

The circuit makes it possible to add various additional compensations in the bias stage without suffering from the effects of large signal swing at the amplifying transistor. For example one or more pull up resistances may be added coupled from the source of the bias transistor to the first and/or intermediate power supply connection.

### Brief description of the drawing

These and other objects and advantageous aspects will become apparent from a description of exemplary embodiments, using the following figures.
Figures 1 to 4 show amplifier circuits
Figures 1a and 3a show a Vgs-Ids characteristic of a normally on transistor

### Detailed description exemplary embodiments

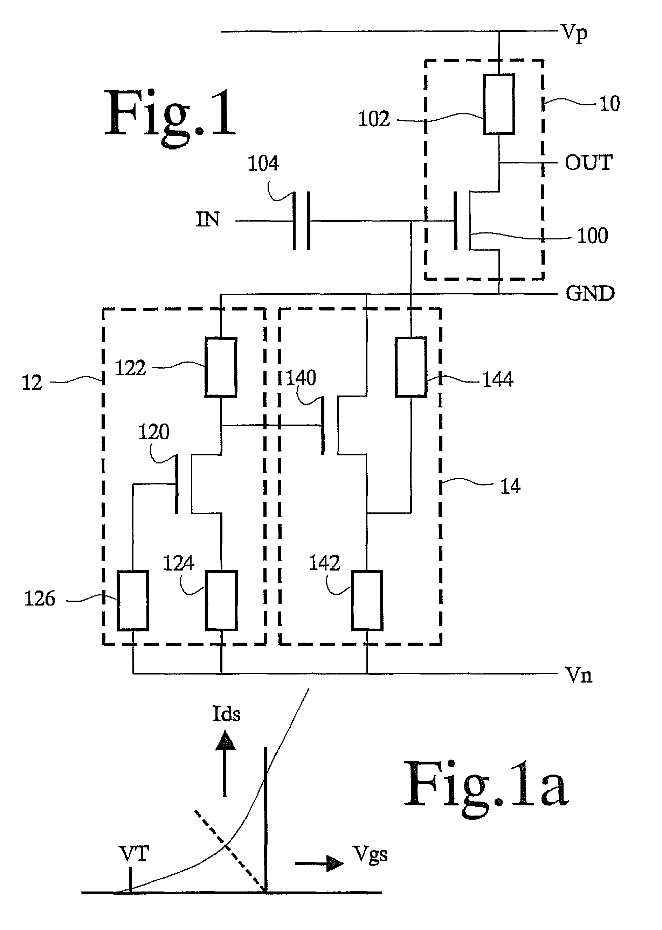

Figure 1 shows an amplifier circuit, comprising an amplifying stage 10 with an amplifying transistor 100, a bias stage 12 with a bias transistor 120 and a buffer stage 14 with a buffer transistor 140 in source follower configuration. Amplifying transistor 100, bias transistor 120 and buffer transistor 140 may be junction FETs or isolated gate FETs for example. The circuit has a positive power supply connection Vp, a negative power supply connection Vn and a ground connection GND. Amplifying transistor 100, a bias transistor 120 and buffer transistor 140 may be transistors of "normally on" type, i.e. transistors with a main current channel that conducts when a zero gate-source voltage is applied and cut off when the gate source voltage is lowered. Figure 1a shows a Vgs-Ids characteristic of a normally on transistor, which shows a function F(Vgs-Vt) that determines Ids as a function of the gate source voltage Vgs and the threshold voltage VT. A qualitative example of the shape of the characteristic is shown as an illustration of principle. The characteristic for real transistors may differ from this qualitative example. When VT shifts, the entire curve shifts. As can be seen in the normally on transistor the transistor operates above its threshold voltage when Vgs=0.

A source of amplifying transistor 100 is coupled to the ground connection. Amplifying stage 10 comprises a drain impedance 102 coupled between the positive power supply connection Vp and coupled to the drain of amplifying transistor 100, a coupling capacitor 104 coupled between an RF input 'IN' and the gate of amplifying transistor 100.

Bias stage 12 comprises a drain resistance 122 coupled between the drain of bias transistor 120 and ground, a source resistance 124 coupled between the source of bias transistor 120 and negative power supply Vn and a gate resistance 126 coupled between the gate of bias transistor 120 and negative power supply Vn. A dashed line in figure 1a illustrates the relation between the gate source voltage of bias transistor 120 and the drain-source current defined by the source resistance. A ratio of the resistance values of drain resistance 122 and source resistance 124 is selected to realize a voltage gain of substantially two from the gate of bias transistor 120 to the gate voltage of amplifying transistor 100. If the gain of buffer stage 14 may be taken to be one, the drain resistance 122 and source resistance 124 may be selected to realize a voltage gain of substantially two from the gate of bias transistor 120 to the drain voltage of bias transistor 120. Although the output of bias stage 12 is shown at a node that forms the drain of bias transistor 120, it will be appreciated that the output could be located elsewhere, for example at a node in a series arrangement of resistances between the drain and ground, or in a more complicated network of resistances. As will be appreciated, it is straightforward to set the gain to the described value in this case as well. The resistance value of gate resistance 126 is not critical, since the DC current to the gate of bias transistor is negligible.

The gate of buffer transistor 140 is coupled to the drain of bias transistor 120. The drain of buffer transistor 140 is coupled to ground. Buffer stage 14 comprises a resistance 142 coupled between the source of buffer transistor 140 to the negative power supply Vn and an RF blocker 144 coupled from the source of buffer transistor 140 to the gate of amplifying transistor 100. RF blocker 144 may be a choke coil for example, but any circuit may be used that conducts DC current and provides a high RF impedance at the gate of transistor 100. The RF impedance ensures that amplifying stage 14 operates properly and well matched, which could be as is the case in many designs a substantially inductive impedance. The RF blocker may also contain a capacitor, connected between the source of transistor 140 to GND.

In operation bias stage 12 supplies a voltage at the drain of bias transistor 120 that depends on the threshold voltage of bias transistor 120. Manufacturing tolerances and/or temperature fluctuations in the threshold voltage result in deviations of the drain voltage that are substantially twice as large. Similarly, between circuits that have the same structure, but different threshold voltages due to manufacturing spread, the drain voltages at the drains of bias transistor 120 will differ by substantially twice the difference in the threshold voltage. The factor between the deviations of the threshold voltage and the drain voltage of bias transistor may be slightly higher than two if buffer transistor 140 is dimensioned so that it produces a gain of less than one, so that the combined gain of bias stage 12 and buffer stage 14 substantially equals two.

Buffer transistor 140 operates in source follower configuration. It transmits the drain voltage of bias transistor 120 to the gate of amplifying transistor 100. Buffer transistor 140 introduces an additional dependence on temperature fluctuations and/or manufacturing spread, due to deviations in its threshold voltage. This dependence reduces the double dependence on deviations at the gate voltage of buffer transistor 140 to a single dependence at its source. In other words, the source voltage has a dependence substantially equal to the deviation of the threshold voltage. As a result the deviation dependence on the threshold voltage of amplifying transistor 100 is compensated.

In a further embodiment, further compensating resistances (not shown) may be added from the source of bias transistor 120 to ground and/or positive power supply Vp. The resistance values of the drain resistance 122 and/or the source resistance 124 may be adapted to realize the gain of two in combination with such additional resistances.

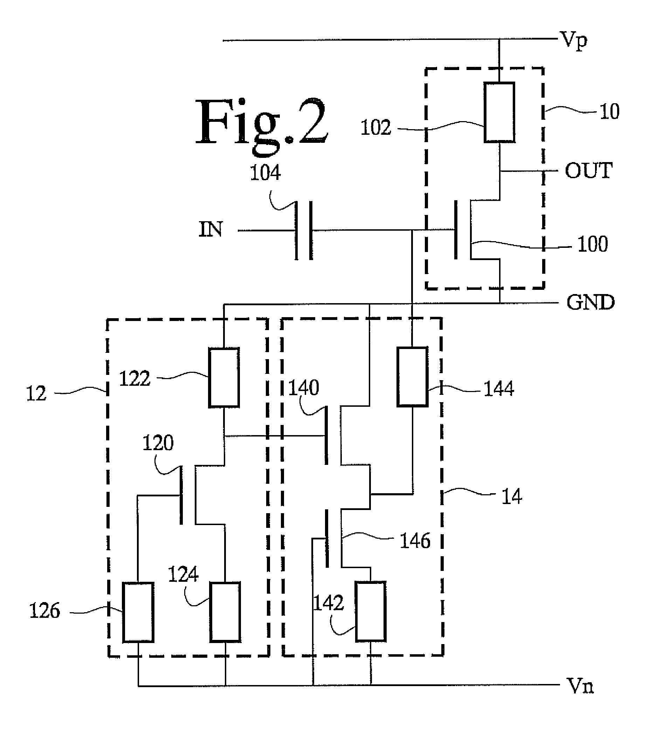

Figure 2 shows a further embodiment wherein a current source transistor 146 has been added to buffer circuit 14. The main current channel of current source transistor 146 is coupled between the source of buffer transistor 140 and the resistance 142 of buffer stage 14. Thus, resistance 142 is coupled between the source of current source transistor 146 and the negative power supply Vn. The gate of transistor 146 is connected to Vn, optionally via a resistor (not indicated in Figure 2). In operation current source transistor 146 and resistance 142 act to supply a constant current to buffer transistor 140. This keeps the gain of buffer stage 14 close to one, which makes it possible to provide for accurate compensation of the deviations without the need to know the parameters of buffer transistor 140 when the gain of bias stage 12 is set.

In another embodiment, a Darlington configuration may be used in buffer stage 14. In this embodiment the gate-source connection of one or more additional transistors may be added in series between the drain of bias transistor 120 and the gate of buffer transistor 140. In this case the additional transistors introduce additional deviation dependence, which can be compensated by using a correspondingly higher gain in bias stage 12, so that the gain from the gate of bias transistor 120 to the gate of amplifying transistor 100 substantially equals N+1, where N is the number of gate-source connections in the signal path through buffer stage 14.

Although not shown, further transistors in other configurations may be included between the drain of the bias transistor and the amplifying transistor. Preferably, the value of the gain of bias stage 12 is set to compensate for amplification or attenuation contributed by such further transistors.

Although an embodiment of a circuit with field effect transistors has been shown, it should be appreciated that a circuit with any other type of transistor, such as bipolar transistors may be used, if circuit components are added to compensate for non-zero base currents. Also, it will be appreciated that the polarity of the power supply connections may be reversed, accompanied by a reversal of the polarity type of the transistors.

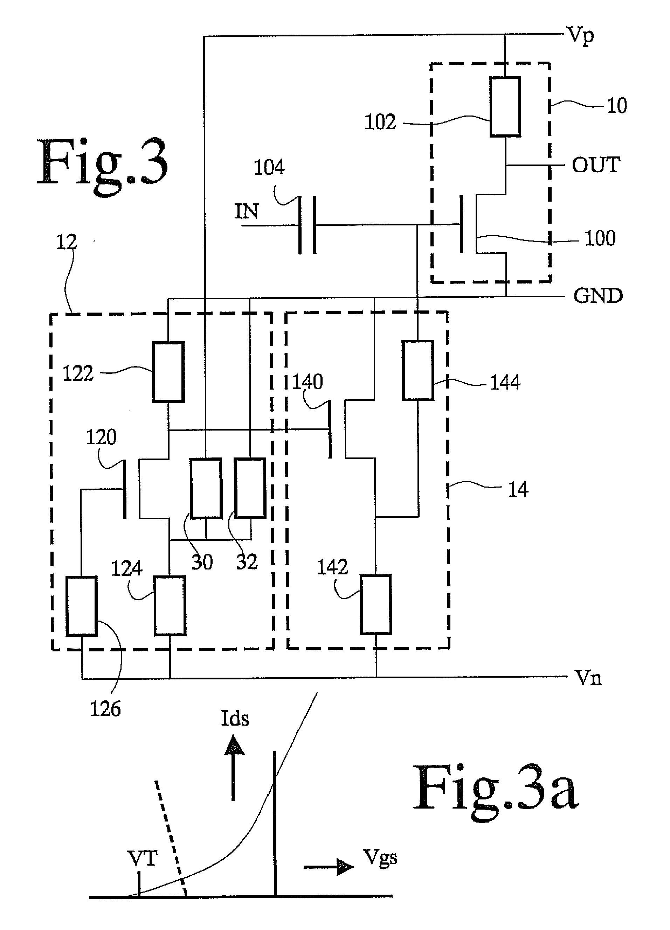

Figure 3 shows an embodiment wherein, pull-up resistors 30, 32 have been added, coupled between the source of bias transistor 120 and GND and Vp respectively. A buffer circuit 14 similar to that of figure 1 is shown, but it should appreciated that alternatively, the buffer circuit of figure 2 may be used. A ratio of the resistance values of drain resistance 122, pull-up resistor 128 and source resistance 124 is selected to realize the voltage gain of substantially two from the gate of bias transistor 120 to the gate voltage of amplifying transistor 100. In other embodiments only one of pull-up resistors 30, 32 may be used, for example only a pull-up resistor to ground, or only a pull-up resistor to the positive power supply.

Basically, as can be shown by conventional circuit analysis, pull-up resistors 30, 32 have the effect that the circuit coupled to the source of bias transistor 120 can be modelled as an effective circuit with an effective voltage source with an output voltage Vq above the level of the negative power supply Vn, in series with an effective resistance Rq that corresponds to the combination of the resistances that are coupled to the source. Figure 3a shows an example of source voltage current relation defined by Vq and Rq with a dashed line, together with a relation between gate-source voltage and source (drain) current of bias transistor 120.

In operation, the drain current satisfies Ids=F(Vgs-VT) and Vgs= -Vq-Ids*Rq, wherein the function F is characteristic of the gate source voltage channel current relation of bias transistor 120. The effective resistance Rq may be made lower than the source resistance. Thus it is easier to realize a raised gain with bias transistor 120 and the effect of transistor parameters other than threshold shift on the bias output is reduced, which results in a more complete compensation for threshold voltage variations. The raised output voltage Vq of the effective voltage source at the source of bias transistor 120 helps to reduce the overall channel current of bias transistor 120, so that a larger drain resistor can be used while maintaining a correct bias voltage for transistor 100. In the present case the selection of the combination of resistances depends on the required gain of the bias stage.

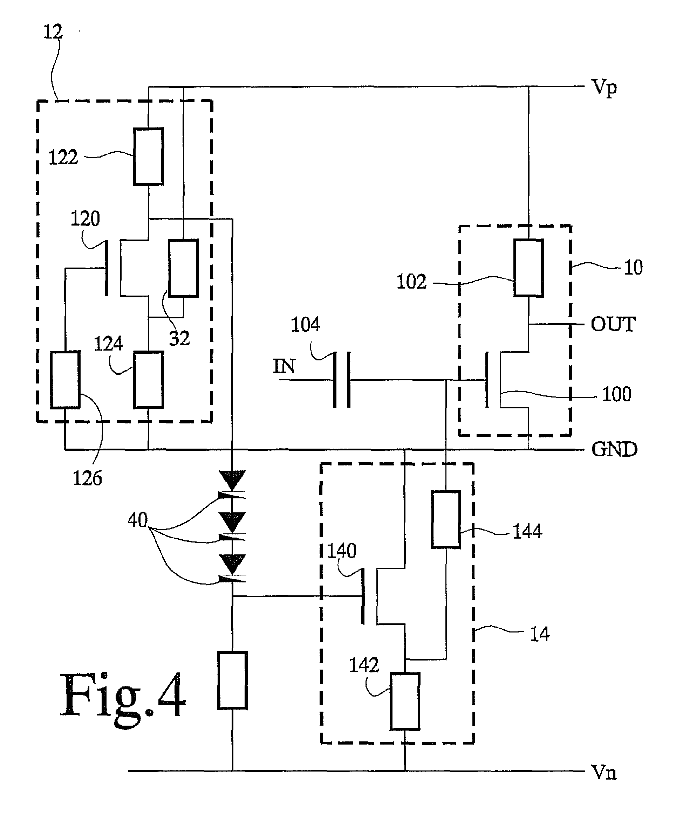

Figure 4 shows an embodiment wherein bias circuit 12 is fed from positive supply connection Vp and ground and a level shift circuit has been added between bias circuit 12 and buffer circuit 14. By way of example, an embodiment is shown wherein the level shift circuit is implemented by means of a series connection of diodes 40 coupled between the output of bias circuit 12 and the input of buffer circuit 14 and a resistance between the input of buffer circuit 14 and the negative power supply. Diodes 40 may be used to provide for additional temperature compensation. Although a pull-up resistor 32 is shown to provide for refined compensation, it should be appreciated that other embodiments this resistor may be omitted. In another embodiment resistor 142 may be replaced by a current source as formed in Fig 2 by FET 146 and resistor 142. In another embodiment with a level shift circuit, bias circuit 12 may be fed from positive supply connection Vp and the negative power supply connection, instead of ground and the negative power supply connection, as shown in figure 1 to 3.

## Claims

1. A power amplifier having first and second power supply connections (Vp, Vn) for supplying power supply voltages of mutually opposite polarity relative to an intermediate power supply connection (Gnd), the power amplifier comprising
- a normally on amplifying transistor (100) with a control electrode, and a main current channel coupled between the first power supply connection (Vp) and the intermediate power supply connection (Gnd);
- a buffer circuit (14) with at least one buffer transistor (140) in source follower configuration; and
- a bias stage (12) with an output coupled to the control electrode of the amplifying transistor (100) via the buffer circuit (14), the bias stage (12) comprising a normally on bias transistor (120) in a reference configuration wherein a current through a main current channel of the bias transistor (120) depends on a threshold voltage value of the bias transistor (120), the combination of the bias stage (12) and the buffer circuit (14) having a voltage gain of substantially an integer factor from a control electrode of the bias transistor (120) to the control electrode of the amplifying transistor (100), the integer factor being equal to one plus a count of buffer transistors (140) coupled between the bias transistor (120) and the amplifying transistor (100) in the buffer circuit (14).

2. A power amplifier according to claim 1, wherein the bias stage (12) comprises a first and second resistance (122, 124) coupled between the main current channel of the bias transistor (120) and mutually different ones of the power supply connections (Vp, Vn) respectively, the first and second resistance (122, 124) having resistance values set to realize said voltage gain.

3. A power amplifier according to claim 1 or 2, wherein the bias transistor (120), the buffer transistor (140) and the amplifier transistor (100) are field effect transistors and the count of buffer transistors (140) is a count of buffer transistors (140) connected in source follower configuration between the bias stage (12) and the amplifying transistor (100).

4. A power amplifier according to claim 3, wherein exactly one buffer transistor (140) is connected in source follower configuration between the output of the bias stage (12) and the control electrode of the amplifying transistor (100) and wherein the integer factor is two.

5. A power amplifier according to any one of the preceding claims, comprising a current source (146) coupled between the main current channel of the buffer transistor (140) and the second power supply connection (Vp).

6. A power amplifier according to claim 2, comprising a further resistance (30) coupled from the source of the bias transistor (120) to the first power supply connection (Vp).

7. A power amplifier according to claim 2 or 6, comprising a further resistance (32) coupled from the source of the bias transistor (120) to the intermediate power supply connection (GND).

8. A method of amplifying a signal, the method comprising
- using a bias transistor to generate a bias voltage at a control electrode of an amplifying transistor,
- buffering an output voltage from the bias transistor with a buffer transistor;
- providing a voltage gain of substantially an integer factor from a control electrode of the bias transistor to the control electrode of the amplifying transistor, wherein the integer factor is equal to one plus a count of buffer transistors coupled between the bias stage and the amplifying transistor in the buffer circuit.
